# EUROPÄISCHE PATENTSCHRIFT

(11) **EP 2 751 490 B1**
(45) Veröffentlichungstag und Bekanntmachung des Hinweises auf die Patenterteilung: **05.05.2021**
(21) Anmeldenummer: 12758816.8
(22) Anmeldetag: 28.08.2012
(51) Int. Cl.: F24C 7/08, F24C 15/10, G05B 19/04

(54) **HAUSHALTSGERÄT MIT BEDIENELEMENT UND VERFAHREN ZUM BETREIBEN EINES HAUSHALTSGERÄTS**
HOUSEHOLD APPLIANCE WITH CONTROL ELEMENT AND AND METHOD FOR OPERATING A HOUSEHOLD APPLIANCE
APPAREIL MÉNAGER À ÉLÉMENT DE COMMANDE ET PROCÉDÉ DE FONCTIONNEMENT D'UN APPAREIL MÉNAGER

(30) Priorität: 30.08.2011 DE 102011081767
(43) Veröffentlichungstag der Anmeldung: 09.07.2014
(73) Patentinhaber: BSH Hausgeräte GmbH, 81739 München (DE)
(72) Erfinder: KOJER, Mario, 83342 Tacherting (DE); MARBACH, Andreas, 83374 Traunwalchen (DE)
(86) Internationale Anmeldenummer: PCT/EP2012/066637
(87) Internationale Veröffentlichungsnummer: WO 2013/030170

(56) Entgegenhaltungen:
- EP-A1- 0 976 862
- EP-A1- 1 691 486
- EP-A2- 1 598 599
- WO-A1-2010/131798
- DE-A1-102005 040 206
- DE-A1-102006 060 379
- DE-A1-102007 008 896
- DE-A1-102008 032 449
- DE-C1- 19 918 290

## Beschreibung

Die Erfindung betrifft ein Haushaltsgerät mit mindestens einem Bedienelement zum Ändern mindestens eines Betriebsparameters des Haushaltsgeräts. Die Erfindung betrifft ferner ein Verfahren zum Betreiben eines Haushaltsgeräts.

Es ist bekannt, dass bei einer Fehlbedienung eines Bedienelements, welches zum Ändern mindestens eines Betriebsparameters des Haushaltsgeräts vorgesehen ist, ein Bediener oder Benutzer diesen Betriebsparameter neu einstellen muss. Dabei tritt die Schwierigkeit auf, dass sich der Bediener häufig an den Wert des durch die Fehlbedienung des Bedienelements verstellten Betriebsparameters nicht mehr erinnert. Es kann sogar vorkommen, dass mit der Fehlbedienung eines Bedienelements mehrere Betriebsparameter verstellt wurden, was eine Neueinstellung weiter erschwert

Die Offenbarung DE 10 2008 032449 A1 beschreibt beispielsweise ein Haushaltsgerät in Form eines Gargeräts, aufweisend ein Rücksetz-Bedienelement.

Es ist die **Aufgabe** der vorliegenden Erfindung, die Nachteile des Standes der Technik zumindest teilweise zu überwinden.

Diese Aufgabe wird gemäß den Merkmalen der unabhängigen Ansprüche gelöst. Bevorzugte Ausführungsformen sind insbesondere den abhängigen Ansprüchen entnehmbar.

Die Aufgabe wird gelöst durch ein Haushaltsgerät mit mindestens einem Bedienelement zum Ändern mindestens eines Betriebsparameters des Haushaltsgeräts. Das Haushaltsgerät weist ferner mindestens ein Rücksetz-Bedienelement auf, welches zum Zurücksetzen oder Zurückstellen zumindest einer zuletzt durchgeführten Änderung vorgesehen ist. So wird der Vorteil erreicht, dass sich ein Bediener nicht mehr an den verstellen Wert zu erinnern braucht, sondern zur Rücksetzung auf den ursprünglichen Wert lediglich das Rücksetz-Bedienelement zu betätigen braucht.. Auch ist eine solche Rückstellung besonders einfach, insbesondere mit wenigen Betätigungen, ausführbar.

Unter einem Bedienelement kann beispielsweise ein körperliches Bedienelement, z.B. ein Schalter, eine Taste, ein Slider usw. verstanden werden, oder z.B. auch ein Bedienfeld eines Sensorfelds usw.

Das Rücksetz-Bedienelement kann insbesondere als ein eigener Schalter oder Taste ausgebildet sein. Der Schalter oder die Taste mag ein körperlicher Schalter oder Taste sein, oder mag z.B. ein Bedienbereich eines Sensorfelds sein. Das Rücksetz-Bedienelement mag eine Funktion einer Multifunktionstaste sein.

Das Zurücksetzen zumindest einer zuletzt durchgeführten Änderung kann ein Zurücksetzen nur einer, der zuletzt durchgeführten Änderung umfassen.

Es ist eine Ausgestaltung, dass das Rücksetz-Bedienelement zum Zurücksetzen mehrerer zuletzt durchgeführter Änderungen, z.B. der zuletzt durchgeführten zwei, drei oder mehr Änderungen eingerichtet ist. Das Zurücksetzen mehrerer Änderungen kann beispielsweise durch ein ebenso häufiges Betätigen des Rücksetz-Bedienelements erfolgen und/oder durch ein länger andauerndes Betätigen des Rücksetz-Bedienelements, falls das Rücksetz-Bedienelement mit einer sog. "Repeat-Funktion" oder Wiederholfunktion ausgestattet ist.

Es ist noch eine Ausgestaltung, dass eine Änderung des mindestens einen Betriebsparameters aufgrund genau einer Betätigung eines zugehörigen Bedienelements erfolgt.

Es ist noch eine Ausgestaltung, dass eine Änderung des mindestens einen Betriebsparameters aufgrund mehrerer, nacheinander ausgeführter Betätigungen mindestens eines Bedienelements erfolgt, wobei zwei direkt nacheinander ausgeführte Betätigungen eine erste vorbestimmte Zeitdauer nicht überschreiten. Dadurch können Serien von Betätigungen, welche hintereinander in ausreichend schneller Abfolge durchgeführt werden, mit einer einzigen Betätigung des Rücksetz-Bedienelements rückgängig gemacht werden oder zurückgesetzt werden. Dabei wird der inhaltliche Zusammenhang zwischen diesen Betätigungen durch die ausreichend schnelle Abfolge hergestellt, wobei die "ausreichend schnelle" Abfolge durch die erste vorbestimmte Zeitdauer bestimmt ist.

Es ist eine weitere Ausgestaltung, dass die vorbestimmte Zeitdauer mindestens ca. eine Sekunde, insbesondere mindestens ca. drei Sekunden, insbesondere ca. fünf Sekunden, beträgt.

Es ist noch eine weitere Ausgestaltung, dass eine Änderung bis zu einer zweiten vorbestimmten Zeitdauer zurücksetzbar ist. Dadurch wird der Vorteil erreicht, dass eine Rücksetzung nur für Änderungen durchgeführt wird, die nicht allzu fern zurückliegen und folglich für eine jetzige Situation wenig Sinn ergeben. Beispielsweise mag durch ein Ausschalten einer Kochstufe eines Kochgeräts nach fünf Minuten eine Temperatur eines Garguts so weit abgekühlt sein, dass ein einfaches Zurücksetzen auf den vorherigen Zustand kein befriedigendes Garergebnis mehr gibt.

Es ist eine Weiterbildung, dass die zweite vorbestimmte Zeitdauer zwischen dreißig Sekunden und zehn Minuten liegt, insbesondere mindestens eine Minute, insbesondere ca. fünf Minuten, dauert.

Es ist eine Weiterbildung, dass die zweite vorbestimmte Zeitdauer abhängig von einem Betriebszustand und/oder einer Änderung des Betriebszustands des Haushaltsgeräts ist. So kann das Haushaltsgerät diesen Betriebszustand erkennen (z.B. anhand von eingestellten Betriebsparametern) und automatisch eine zugehörige zweite vorbestimmte Zeitdauer zuordnen, insbesondere automatisch durch das Haushaltsgerät. Dies ermöglicht eine besonders effektiv zugeordnete Zurücksetzung. Beispielsweise kann bei einem Kochfeld in Abhängigkeit von einem Wert einer Kochstufe vor einer Änderung, nach der Änderung und/oder der Größe der Änderung die zweite vorbestimmte Zeitdauer eingestellt werden.

Es ist ferner eine Ausgestaltung, dass eine Änderung nach einem Ausschalten des Haushaltsgeräts bis zu einer dritten vorbestimmten Zeitdauer zurücksetzbar ist, welche insbesondere kleiner ist als die zweite vorbestimmte Zeitdauer. Durch das Vorsehen der dritten vorbestimmten Zeitdauer wird verhindert, dass ein Rücksetzen eines gewollt ausgeschalteten und viel später neu eingeschalteten Haushaltsgeräts auf Betriebsparameterwerte vor dem Ausschalten durchgeführt werden kann.

Es ist eine Weiterbildung, dass die dritte vorbestimmte Zeitdauer maximal ca. eine Minute beträgt. Beispielsweise kann das Haushaltsgerät so bis zum Erreichen oder Überschreiten der dritten Zeitdauer nach einem Ausschalten wieder eingeschaltet werden und mittels des Zurücksetz-Bedienelements wieder zumindest auf den vor dem Ausschalten vorliegenden Zustand zurückgestellt werden.

Das Einschalten des Haushaltsgeräts und das Zurücksetzen auf die vor dem Einschalten gültigen Betriebsparameterwerte kann beispielsweise durch ein Betätigen des Hauptschalters und dann des Zurücksetz-Bedienelements geschehen oder auch durch ein Betätigen nur des Zurücksetz-Bedienelements (insbesondere innerhalb der dritten vorbestimmten Zeitdauer). Diese Alternativen stehen insbesondere auch für den Fall bereit, dass das Ausschalten automatisch durchgeführt wurde, insbesondere nach einem Feststellen einer langen Dauerbetätigung.

Es ist ferner eine Weiterbildung, dass mittels des Zurücksetz-Bedienelements während eines normalen Betriebs vorgenommene Änderungen zurücksetzbar sind. Unter einem normalen Betrieb kann insbesondere ein Betrieb zwischen einem Einschalten und einem Ausschalten des Haushaltsgeräts verstanden werden. Es ist eine spezielle Weiterbildung, dass nur während eines normalen Betriebs vorgenommene Änderungen zurücksetzbar sind. Insbesondere in diesem Fall mögen Änderungen nach einem Ausschalten des Haushaltsgeräts nicht mehr zurückgesetzt werden, beispielsweise da mit dem Ausschalten ein zugehöriger Speicher oder Speicherbereich gelöscht wird.

Es ist auch eine Ausgestaltung, dass bestimmte Änderungen (insbesondere Änderungen bestimmter Parameter) rücksetzbar sind und andere Änderungen (insbesondere Änderungen anderer Parameter) nicht rücksetzbar sind. Dadurch kann das Zurücksetzen noch bedienerfreundlicher gestaltet werden. Es wird hierbei ausgenutzt, dass einige Betriebsparameter einfach und intuitiv rücksetzbar sind, während eine Rücksetzung von anderen Betriebsparametern entweder mit anderen Mitteln genauso einfach durchführbar ist oder keine intuitiv nachvollziehbare Rücksetzung ermöglicht.

Es ist eine Weiterbildung, dass Änderungen eines Betriebsparameters insbesondere dann rücksetzbar sind, wenn dieser Betriebsparameter mehr als zwei Werte annehmen kann. Dass ein Betriebsparameter mehr als zwei Werte annehmen kann, kann insbesondere bedeuten, dass er einen Betriebsparameterbereich umfasst, z.B. mehrere Kochstufen. Jedoch können grundsätzlich auch Änderungen eines Betriebsparameters rücksetzbar sein, welcher zwei oder weniger Werte annehmen kann.

Die nicht zurücksetzbaren Änderungen können insbesondere Änderungen umfassen, welche eine Funktion aktivieren oder zuschalten (z.B. eine Bratsensorik aktivieren) oder einen Ablauf auslösen (z.B. ein Anlaufen eines Timers oder eine Programmautomatik auslösen). Die nicht zurücksetzbaren Änderungen können insbesondere Änderungen umfassen, welche nur einer Gerätesteuerung dienen (z.B. ein Auslösen einer "Select"-Taste oder einer Menü-Taste).

Erfindungsgemäß ist vorgesehen, dass ein Zurücksetzen durch das Rücksetz-Bedienelement erst dann auslösbar ist, wenn keine Fehlbetätigung vorliegt. So kann eine auf das Zurücksetzen unmittelbar folgende, erneute Änderung aufgrund der nicht beseitigten Betätigungsfehlfunktion vermieden werden.

Ein Zurücksetzen durch das Rücksetz-Bedienelement ist erst dann auslösbar, wenn keine Fehlbetätigung eines zurücksetzbaren Bedienelements vorliegt. Das Rücksetz-Bedienelement mag hierbei also auslösen, und ein Rücksetzen mag jedoch durchgeführt werden, wenn eine Fehlbetätigung eines nicht zurücksetzbaren Bedienelements vorliegt.

Hierbei ist die Fehlbetätigung eine Dauerbetätigung. Dabei wird angenommen, dass ein bestimmtes Bedienelement nicht länger als eine vierte vorbestimmte Zeitdauer betätigt zu werden braucht und/oder üblicherweise nicht länger als die vierte vorbestimmte Zeitdauer betätigt wird. Wird also ein bestimmtes Bedienelement so lange wie oder länger als die vierte vorbestimmte Zeitdauer betätigt, wird eine Fehlbetätigung angenommen. Diese Dauerbetätigung kann beispielsweise bei einem Auflegen von Gegenständen auf das mindestens eine Bedienelement oder bei einem Verschütten von elektrisch leitfähiger Flüssigkeit, z.B. Nudelwasser, auf einem kapazitiv ansprechenden Sensorfeld erzeugt werden. Eine andere Art von Fehlbetätigung mag, je nach Bediensteuerung, z.B. eine gleichzeitige Betätigung mehrerer Bedienelemente umfassen.

Es ist noch eine Ausgestaltung, dass das Rücksetz-Bedienelement mit einer Speichereinrichtung gekoppelt ist, wobei die Speichereinrichtung dazu eingerichtet ist, die zumindest eine zuletzt durchgeführte Änderung abzuspeichern. Dadurch wird eine einfache Rücksetzung ermöglicht. Die Speichereinrichtung mag z.B. eine dem Rücksetz-Bedienelement fest zugeordnete Speichereinrichtung sein oder mag als ein Speicherbereich einer Speichereinheit einer zentralen Steuereinheit des Haushaltsgeräts vorliegen.

Es ist eine Weiterbildung, die zumindest eine Änderung mit einer jeweiligen Betätigung des Rücksetz-Bedienelements zurückzuspeichern (und zwar in einen Speicher oder in Speicherbereiche, in denen die Werte der Betriebsparameter bei einem Betrieb des Haushaltsgeräts abspeicherbar oder abgespeichert sind). Das Zurückspeichern ermöglicht eine besonders einfach umsetzbare Rücksetzung.

Es ist eine Weiterbildung, dass mindestens ein Betriebsparameter automatisch änderbar ist und mit jeder (also auch einer automatischen) Änderung, welche er erfährt, abspeicherbar ist oder abgespeichert wird. Dadurch können auch sich zeitlich ändernde Betriebsparameter auf unmittelbar vor einer Änderung gültige Werte zurückgestellt werden und nicht nur auf ursprünglich eingestellte Werte. Eine solche Änderung kann auch eine automatische Änderung des Betriebsparameters sein.

Der mindestens eine vorbestimmte Betriebsparameter kann insbesondere mindestens eine laufende Zeitdauer umfassen, insbesondere eine Timerzeit und/oder eine Ankochzeit.

Es ist noch eine allgemeine Weiterbildung, dass nur Änderungen zurücksetzbar sind, welche durch eine manuelle Betätigung eines Bedienelements vorgenommen worden sind. Automatisch vorgenommene Änderungen, z.B. ein mittels einer Steuereinrichtung durchgeführtes automatisches Herunterzählen einer Zeitdauer, sind dabei folglich nicht durch eine Betätigung des Rücksetz-Bedienelements zurücksetzbar. Insbesondere mag eine Änderung eines manuell und automatisch änderbaren Betriebsparameters nur dann zurücksetzbar sein, wenn die Änderung manuell vorgenommen worden ist, und ansonsten der Wert des Betriebsparameters nur aktualisiert werden.

Es ist ferner eine Ausgestaltung, dass eine Speicherung einer Änderung automatisch löschbar ist (d.h. gelöscht wird oder erst gar nicht vorgenommen wird), falls der zugehörige mindestens eine Betriebsparameter durch die Änderung nicht verändert worden ist. Dies mag beispielsweise bei einer Änderung eines Betriebsparameters vorliegen, bei welcher ein Zielwert einem Anfangswert entspricht. So kann Speicherplatz eingespart werden, und ein Bediener wird bei einer Zurücksetzung nicht dadurch verwirrt, dass er mit einer Betätigung des Rücksetz-Bedienelements keine Änderung erkennt.

Es ist eine Weiterbildung, dass die Speicherung einer Änderung automatisch löschbar ist, falls der zugehörige mindestens eine Betriebsparameter, ohne Berücksichtigung mindestens einer automatisch durchgeführten Änderung, durch die Änderung nicht verändert worden ist. Die Speicherung der Änderung ist also auch dann automatisch löschbar, falls sich seit der letzten, manuell vorgenommenen Änderung ein Betriebsparameter automatisch verstellt hat.

Das Haushaltsgerät kann grundsätzlich jedes Haushaltsgerät umfassen, insbesondere ein Küchengerät, insbesondere ein Gargerät.

Es ist noch eine Ausgestaltung, dass das Haushaltsgerät ein Gargerät in Form eines Kochgeräts mit einem Kochfeld ist. Die Erfindung ist insbesondere für diese Ausgestaltung vorteilhaft einsetzbar, da speziell bei einem Kochvorgang viele Einstellungen vorgenommen werden und auch geändert werden.

Insbesondere bei einem Kochgerät sind beispielsweise folgende Änderungen rücksetzbar: eine Einstellung einer Kochstufe, eine Einstellung einer Zonenzuschaltung, eine Einstellung eines Ankochstoßes (insbesondere dessen Aktivierung, ggf. auch einer Zeitdauer und/oder einer Höhe) und/oder eine Einstellung (einschließlich Aktivierung) einer Timerzeit.

Beispielsweise mögen folgende Änderungen nicht rücksetzbar sein: eine Aktivierung eines Timers, eine Aktivierung einer Bratsensorik, eine Aktivierung einer Programmautomatik, eine Aktivierung einer Auswahl/Menü-Taste, eine Aktivierung einer Kindersicherung, eine Aktivierung eines Wischschutzes (insbesondere durch eine Betätigung eines jeweils zugeordneten Bedienelements) und/oder eine Aktivierung der mindestens einen Kochstelle durch Betätigen des Hauptschalters.

Es ist noch eine Weiterbildung, dass mit einer Rückstellung des mindestens einen Betriebsparameters eine zugehörige Anzeige des Werts des Parameters zurückgestellt wird, falls vorhanden. Die Anzeige kann z.B. eine alphanumerische Anzeige sein und/oder eine Symbolanzeige sein.

Die Aufgabe wird auch gelöst durch ein Verfahren zum Betreiben eines Haushaltsgeräts, wobei zumindest eine zuletzt durchgeführte Änderung eines Betriebsparameters mittels eines Bedieners zurücksetzbar ist.

Das Verfahren ergibt die gleichen Vorteil wie das Haushaltsgerät und kann auch analog ausgestaltet werden. So mag die Änderung mittels einer Betätigung eines Rücksetz-Bedienelements durchführbar sein. Auch mag die mindestens eine Änderung zumindest während eines normalen Betriebs zurücksetzbar sein.

In den folgenden Figuren wird die Erfindung anhand eines Ausführungsbeispiels schematisch genauer beschrieben. Dabei können zur Übersichtlichkeit gleiche oder gleichwirkende Elemente mit gleichen Bezugszeichen versehen sein.
- Fig.1: zeigt in Draufsicht einen Ausschnitt aus einem Kochfeld mit Blick auf ein Bedienfeld, wobei sich das Bedienfeld in einem ersten Betätigungszustand befindet;
- Fig.2: zeigt das Bedienfeld in einem zweiten Betätigungszustand, bei dem zusätzlich zu dem ersten Betätigungszustand eine Änderung eines Betriebsparameters vorgenommen wurde;
- Fig.3: zeigt das Bedienfeld in einem dritten Betätigungszustand, bei dem zusätzlich zu dem zweiten Betätigungszustand eine weitere Änderung eines Betriebsparameters vorgenommen wurde;
- Fig.4: zeigt das Bedienfeld in einem vierten Betätigungszustand, bei dem zusätzlich zu dem dritten Betätigungszustand noch eine weitere Änderung eines Betriebsparameters vorgenommen wurde;
- Fig.5: zeigt das Bedienfeld in einem fünften Betätigungszustand, bei dem zusätzlich zu dem vierten Betätigungszustand noch eine weitere Änderung eines Betriebsparameters vorgenommen wurde;
- Fig.6: zeigt das Bedienfeld in einem sechsten Betätigungszustand, bei dem zusätzlich zu dem fünften Betätigungszustand noch eine weitere, unbeabsichtigte Änderung eines Betriebsparameters vorgenommen wurde; und
- Fig.7: zeigt das Bedienfeld in einem siebten Betätigungszustand, bei dem zusätzlich zu dem sechsten Betätigungszustand noch eine weitere, unbeabsichtigte Änderung eines Betriebsparameters vorgenommen wurde.

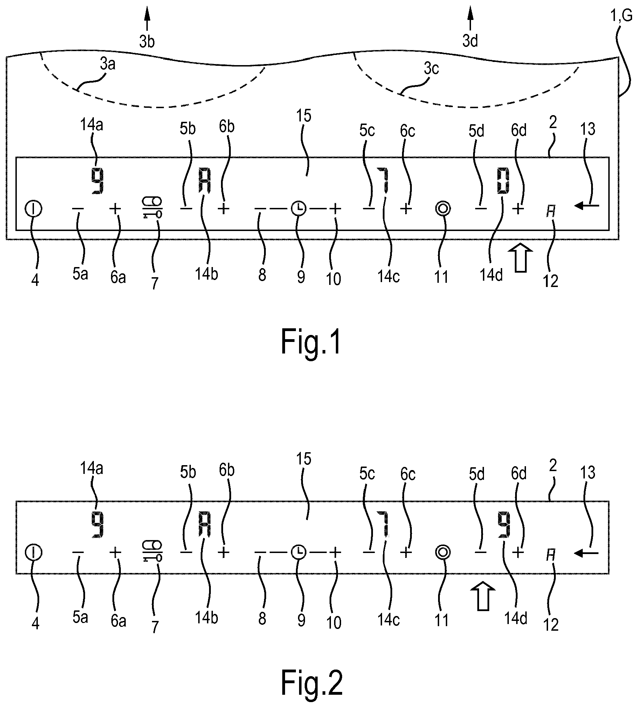

**Fig.1** zeigt in Draufsicht einen Ausschnitt aus einem Kochfeld 1 eines Kochgeräts G (z.B. eines Herds oder eines eigenständigen Kochfelds) mit Blick auf ein Bedienfeld 2, wobei sich das Bedienfeld 2 in einem ersten Betätigungszustand befindet. Oberhalb des Bedienfelds 2 sind zwei von insgesamt vier mittels des Bedienfelds 2 bedienbaren Kochstellen 3a-d gezeigt. Das Bedienfeld 2 ist als ein, beispielsweise kapazitives, Sensorfeld ausgestaltet und weist mehrere in einer Reihe angeordnete (Sensor-)Tasten 4, 5a-d, 6a-d, 7 bis 13 sowie Anzeigefelder 14a-d und 15 auf.

Im Einzelnen sind dies ein an einem linken Rand angeordneter Hauptschalter 4 zum Einschalten und Ausschalten des Kochfelds 1. Dabei kann das Kochgerät G weiterhin mit Strom versorgt werden, z.B. zum Anzeigen einer Fehlerbedingung, jedoch sind zumindest die Kochstellen 3a, 3c stromlos geschaltet.

Rechts neben dem Hauptschalter 4 befindet sich eine Herunterschalttaste oder "-"-Taste 5a zum Herunterschalten einer Kochstufe der Kochstelle 3a. Die Kochstufe kann hier beispielhaft zwischen "9" (maximale Leistung) und "0" (ausgeschaltete Kochstelle) in Vollschritten oder Halbschritten und/oder auch in vorbestimmten Stufen heruntergeschaltet werden. Die "-"-Taste 5a weist die Repeatfunktion auf, d.h., dass sie bei einer anhaltenden Betätigung mehrfach herunterschaltet.

Rechts neben der "-"-Taste 5a befindet sich eine Heraufschalttaste oder "+"-Taste 6a zum Heraufschalten der Kochstufe der Kochstelle 3a, maximal zwischen "0" und "9". Auch die "+"-Taste 6a weist eine sog. Repeatfunktion auf, d.h., dass sie bei einer anhaltenden Betätigung mehrfach heraufschaltet.

Rechts neben der "+"-Taste 6a befindet sich eine Sicherungstaste 7, bei deren Betätigung eine Kindersicherung eine Betätigung der anderen Tasten 4, 5a-d, 6a-d, 8 bis 13 unterbindet. Die Kindersicherung kann durch nochmaliges Betätigen der Sicherungstaste 7 wieder aufgehoben werden.

Rechts neben der Sicherungstaste 7 befinden sich eine "-"-Taste 5b und eine "+"-Taste 6b, welche analog zu der "-"-Taste 5a und der "+"-Taste 6a betätigbar sind bzw. funktionieren, jedoch nun für die hinter der Kochstelle 3a befindliche Kochstelle 3b.

Rechts neben der "+"-Taste 6b befinden sich in dieser Reihenfolge eine Herunterschalt-Timertaste oder "-"-Timertaste 8, eine Timeraktivierungstaste 9 und eine Heraufschalt-Timertaste oder "+"-Timertaste 10. Durch die Timeraktivierungstaste 9 kann ein Timer aktiviert werden und durch die "-"-Timertaste 8 und die "+"-Timertaste 10 verstellt werden, insbesondere auch heruntergestellt bzw. heraufgestellt werden, ggf. mit einer Repeatfunktion.

Rechts neben der "+"-Timertaste 10 befinden sich eine "-"-Taste 5c und eine "+"-Taste 6c, welche analog zu der "-"-Taste 5a und der "+"-Taste 6a betätigbar sind bzw. funktionieren, jedoch nun für die Kochstelle 3c.

Rechts neben der "+"-Taste 6c befindet sich eine Zonenzuschalttaste 11, mit welcher eine Kochstellenerweiterung oder Kochzone einer Kochstelle zuschaltbar ist, z.B. der hinter der Kochstelle 3c befindlichen Kochstelle 3d.

Rechts neben der Zonenzuschalttaste 11 befinden sich eine "-"-Taste 5d und eine "+"-Taste 6d, welche analog zu der "-"-Taste 5a und der "+"-Taste 6a betätigbar sind bzw. funktionieren, jedoch nun für die hinter der Kochstelle 3c befindliche Kochstelle 3d.

Rechts neben der "+"-Taste 6c befindet sich eine Ankochstoß-Zuschalttaste 12, mit welcher ein Ankochstoß aktivierbar ist.

Rechts neben der Ankochstoß-Zuschalttaste 12, und damit am rechten Rand des Bedienfelds 2, befindet sich ein Rücksetz-Bedienelement in Form einer Rücksetztaste 13.

Oberhalb der Tasten 4, 5a-d, 6a-d, 7 bis 13 befinden sich die Anzeigefelder 14a-d und 15, und zwar von links nach rechts in dieser Reihenfolge: eine einstellige Segmentanzeige 14a zur Anzeige einer Kochstufe der Kochstelle 3a, eine einstellige Segmentanzeige 14b zur Anzeige einer Kochstufe der Kochstelle 3b, eine zweistellige Timeranzeige 15 zur Anzeige der aktuellen Timerzeit, eine einstellige Segmentanzeige 14c zur Anzeige einer Kochstufe der Kochstelle 3c und eine einstellige Segmentanzeige 14d zur Anzeige einer Kochstufe der Kochstelle 3d.

In dem gezeigten ersten Betätigungszustand ist das Kochfeld 1 eingeschaltet, und Kochstelle 3a befindet sich auf einer Kochstufe "9", Kochstelle 3b führt einen Ankochstoß "A" aus, Kochstelle 3c befindet sich auf einer Kochstufe "7" und Kochstelle 3d ist angeschaltet, befindet sich aber auf Kochstufe "0". Eine Zonenzuschaltung für die Kochstelle 3d ist aktiv (zugehöriges Lämpchen o.Abb.).

Durch eine Betätigung der "+"-Taste 6d lässt sich, wie durch den unterhalb des Bedienfelds 2 eingezeichneten Pfeil angedeutet, die Kochstufe der Kochstelle 3d von "0" auf "9" erhöhen, und zwar durch entsprechend häufiges Betätigen der "+"-Taste 6d oder durch eine Nutzung der Repeatfunktion. Die "+"-Taste 6d (wie auch die "+"-Tasten 6a bis 6c) kann bei einer ersten Betätigung nach Einschalten des Kochfelds 1 die Kochstufe auch auf eines vorbestimmtes Niveau einstellen und erst bei einer folgenden Betätigung die Kochstufe nacheinander hochstellen. Eine solche Änderung eines Betriebsparameters zählt aufgrund seiner ausreichend schnellen Abfolge als eine einzige Änderung.

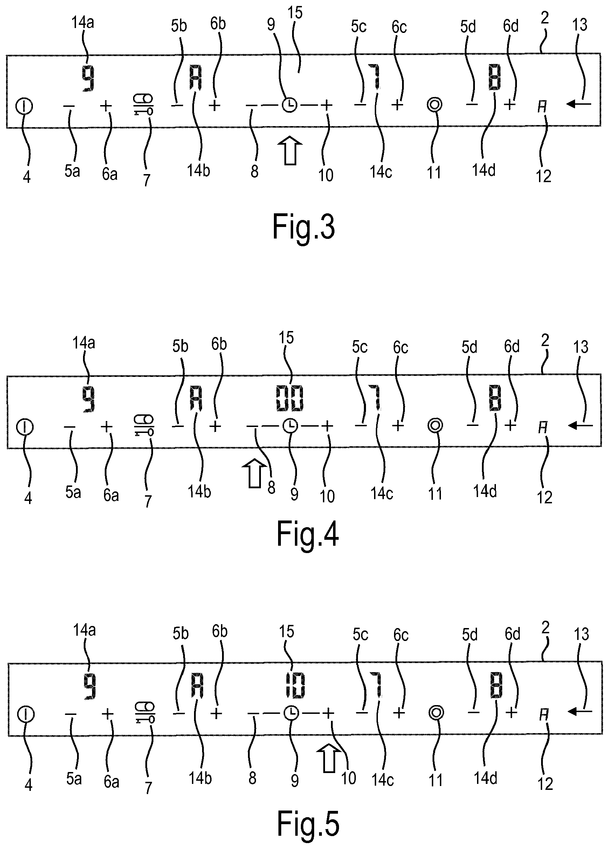

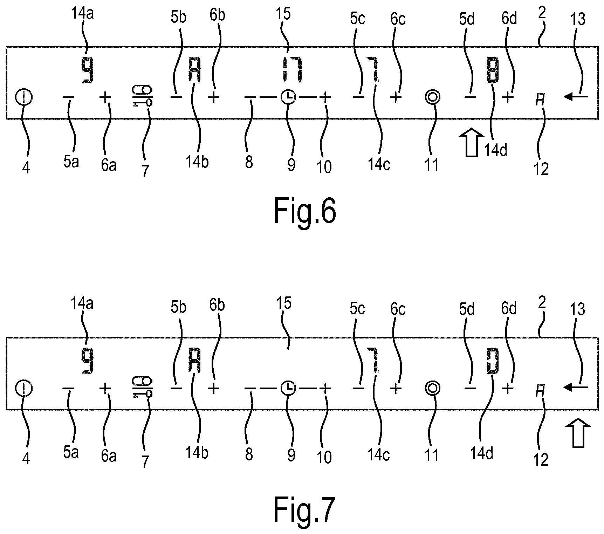

Der entsprechend verstellte Zustand des Bedienfelds 2 und damit auch des Kochfelds 1 ist in **Fig.2** gezeigt. Nun kann, wie durch den Pfeil angedeutet, die Kochstufe der Kochstelle 3d durch mindestens eine einmalige, kurze Betätigung der "-"-Taste 5d auf "8" heruntergestellt werden, was in **Fig.3** gezeigt ist. Folgend kann durch eine Betätigung der Timertaste 9 der Timer eingestellt werden, wodurch sich die Timeranzeige 15 zunächst auf "00" stellt, was in **Fig.4** gezeigt ist. Der Timer kann durch ein Betätigen der "-"-Timertaste 8 aus der "00"-Stellung in Zehnerschritten oder in anderen vorbestimmten Zeitschritten heraufgestellt werden (z.B. auf einen Wert "10", wie in **Fig.5** gezeigt) gezeigt und durch ein (insbesondere mehrmaliges) Betätigen der "+"-Timertaste 10 in Einzelschritten (Minutenschritten) verstellt werden (z.B. auf einen Wert "17", wie in **Fig.6** gezeigt).

Durch das in **Fig.6** durch den Pfeil angedeutete unbeabsichtigte schnell aufeinanderfolgende oder durch die Repeatfunktion ermöglichte Herunterstellen der Kochstufe der Kochstelle 3d aufgrund einer entsprechenden Betätigung der "-"-Taste 5d wird nicht nur die Kochstufe der Kochstelle 3d verstellt, sondern werden auch der für diese Kochstelle 3d vorgesehene Timer und ggf. eine zuvor aktivierte Zonenzuschaltung deaktiviert. Dies wird als eine einzige Änderung ausgelegt. Bei dieser Änderung werden also durch eine Betätigung nur eines Bedienelements mehrere Betriebsparameter geändert.

Durch eine folgende Betätigung des Rücksetz-Bedienelements 13 werden, wie durch den Pfeil in **Fig.7** angedeutet, die durch die letzte Betätigung der "-"-Taste 5d erzeugten Änderungen rückgängig gemacht oder zurückgesetzt, nämlich die zugehörige Kochstufe der Kochstelle 3d auf "8" zurückgesetzt, der Timer aktiviert und wieder auf den Wert "17" gesetzt, wie bereits in Fig.6 gezeigt. Die Anzeigen 14d und 15 werden entsprechend zurückgestellt.

Durch ein nochmaliges Betätigen des Rücksetz-Bedienelements 13 könnten weitere Änderungen (in umgekehrter Reihenfolge ihrer Durchführung) zurückgesetzt werden, z.B. dann der Timer wieder auf den Wert "10" gestellt werden usw. Dabei wird angenommen, dass die zwischen den gezeigten Figuren durchgeführten Änderungen mit einem zeitlichen Abstand durchgeführt worden sind, welcher größer ist als eine vorbestimmte erste Zeitdauer von hier z.B. drei Sekunden.

Wäre die Timerfunktion bereits angelaufen, wobei die Timerzeit von dem Kochgerät G eigenständig in Minuten zurückgezählt wird, und wäre dann erst die unbeabsichtigte Betätigung der "-"-Taste 5d erfolgt, würde durch eine Betätigung des Rücksetztaste 13 die zugehörige Kochstufe der Kochstelle 3d auf "8" zurückgesetzt werden, der Timer aktiviert und auf den dann aktuellen Wert zurückgesetzt werden (welcher auch kleiner als "17" sein kann).

Selbstverständlich ist die vorliegende Erfindung nicht auf das gezeigte Ausführungsbeispiel beschränkt.

So ist die Erfindung nicht auf Sensorfelder beschränkt.

Auch kann das Bedienfeld weitere, z.B. im allgemeinen Beschreibungsteil aufgeführte Eigenschaften aufweisen.

So kann dann, wenn ausgehend von Fig.1 als nächste Betätigung ein Ausschalten des Hauptschalter vorgenommen wird (alle Kochstellen auf Kochstufe "0", d.h. ausgeschaltet, entsprechend Segmentanzeigen 14a-d auf Anzeige "0", Timeranzeige 15 deaktiviert, keine Zusatzfunktionen wie eine Zonenzuschaltung, ein Timer oder ein Ankochstoß aktiviert), durch die Betätigung der Rücksetztaste 13 die Einstellung des Kochfelds 1 gemäß Fig.1 wieder hergestellt bzw. wieder darauf zurückgestellt werden, falls die Betätigung der Rücksetztaste 13 innerhalb von fünf Minuten erfolgt, ggf. erst nach einer erneuten Betätigung des Hauptschalters 4.

### Bezuaszeichenliste

- 1: Kochfeld
- 2: Bedienfeld
- 3i: Kochstelle i
- 4: Hauptschalter
- 5i: "-"-Taste der Kochstelle i
- 6: "+"-Taste der Kochstelle i
- 7: Sicherungstaste
- 8: "-"-Timertaste
- 9: Timeraktivierungstaste
- 10: "+"-Timertaste
- 11: Zonenzuschalttaste
- 12: Ankochstoß-Zuschalttaste
- 13: Rücksetztaste
- 14i: Anzeigefeld für die Kochstelle i
- 15: Timeranzeige
- G: Kochgerät

## Patentansprüche

1. Haushaltsgerät (1, G) mit mindestens einem Bedienelement (4, 5a-d, 6a-d, 7-12) zum Ändern mindestens eines Betriebsparameters des Haushaltsgeräts (1, G) und einer Steuereinrichtung, welches Haushaltsgerät (1, G) zusätzlich ein Rücksetz-Bedienelement (13) aufweist, das zum Zurücksetzen zumindest einer mittels des mindestens einen anderen Bedienelements (4, 5a-d, 6a-d, 7-12) zuletzt durchgeführten Änderung vorgesehen ist, **dadurch gekennzeichnet, dass** das Zurücksetzen durch das Rücksetz-Bedienelement (13) erst dann durch die Steuereinrichtung auslösbar ist, wenn keine Fehlbetätigung des mindestens einen anderen Bedienelements (4, 5a-d, 6a-d, 7-12) in Form einer Dauerbetätigung, die dann angenommen wird, wenn mindestens eine vorbestimmte Zeitdauer erreicht oder überschritten worden ist, vorliegt.

2. Haushaltsgerät (1, G) nach Anspruch 1, **dadurch gekennzeichnet, dass** das Rücksetz-Bedienelement (13) zum Zurücksetzen mehrerer zuletzt durchgeführter Änderungen eingerichtet ist.

3. Haushaltsgerät (1, G) nach einem der vorhergehenden Ansprüche, **dadurch gekennzeichnet, dass** eine Änderung des mindestens einen Betriebsparameters aufgrund genau einer Betätigung eines zugehörigen Bedienelements (5d) erfolgt.

4. Haushaltsgerät (1, G) nach einem der vorhergehenden Ansprüche, **dadurch gekennzeichnet, dass**
- eine Änderung des mindestens einen Betriebsparameters aufgrund mehrerer, nacheinander ausgeführter Betätigungen mindestens eines Bedienelements (5d) erfolgt, wobei nacheinander ausgeführte Betätigungen eine erste vorbestimmte Zeitdauer nicht überschreiten und
- diese Änderung mittels einer einzigen Betätigung des Rücksetz-Bedienelements (13) zurückgesetzt werden.

5. Haushaltsgerät (1, G) nach Anspruch 4, **dadurch gekennzeichnet, dass** die vorbestimmte erste Zeitdauer mindestens drei Sekunden beträgt.

6. Haushaltsgerät (1, G) nach einem der vorhergehenden Ansprüche, **dadurch gekennzeichnet, dass** eine Änderung bis zu einer zweiten vorbestimmten Zeitdauer, insbesondere ca. fünf Minuten, zurücksetzbar ist.

7. Haushaltsgerät (1, G) nach Anspruch 6, **dadurch gekennzeichnet, dass** eine Änderung nach einem Ausschalten des Haushaltsgeräts (1, G) bis zu einer dritten vorbestimmten Zeitdauer zurücksetzbar ist, welche kürzer als die zweite vorbestimmte Zeitdauer ist.

8. Haushaltsgerät (1, G) nach einem der vorhergehenden Ansprüche, **dadurch gekennzeichnet, dass** bestimmte Änderungen rücksetzbar sind und andere Änderungen nicht rücksetzbar sind.

9. Haushaltsgerät (1, G) nach einem der vorhergehenden Ansprüche, **dadurch gekennzeichnet, dass** das Rücksetz-Bedienelement (13) mit einer Speichereinrichtung gekoppelt ist, wobei die Speichereinrichtung dazu eingerichtet ist, die zumindest eine zuletzt durchgeführte Änderung abzuspeichern und die zumindest eine Änderung mit einer jeweiligen Betätigung des Rücksetz-Bedienelements (13) zurückzuspeichern.

10. Haushaltsgerät (1, G) nach einem der vorhergehenden Ansprüche, **dadurch gekennzeichnet, dass** mindestens ein Betriebsparameter, insbesondere mindestens eine laufende Zeitdauer, mit jeder Änderung, welche er erfährt, abgespeichert wird.

11. Haushaltsgerät (1, G) nach einem der vorhergehenden Ansprüche, **dadurch gekennzeichnet, dass** eine Speicherung einer Änderung automatisch löschbar ist, falls der zugehörige mindestens eine Betriebsparameter, insbesondere ohne Berücksichtigung mindestens einer laufenden Zeitdauer, durch die Änderung nicht verändert worden ist.

12. Haushaltsgerät (1, G) nach einem der vorhergehenden Ansprüche, **dadurch gekennzeichnet, dass** das Haushaltsgerät ein Kochgerät (G) mit einem Kochfeld ist (1).

13. Haushaltsgerät (1, G) nach Anspruch 12 in Verbindung mit Anspruch 8, **dadurch gekennzeichnet, dass** folgende Änderungen rücksetzbar sind: eine Einstellung einer Kochstufe, eine Einstellung einer Zonenzuschaltung, eine Einstellung eines Ankochstoßes und/oder eine Einstellung einer Timerzeit.

14. Haushaltsgerät (1, G) nach einem der Ansprüche 12 oder 13 in Verbindung mit Anspruch 8, **dadurch gekennzeichnet, dass** folgende Änderungen nicht rücksetzbar sind: eine Aktivierung eines Timers (9), eine Aktivierung einer Bratsensorik, eine Aktivierung einer Programmautomatik, eine Aktivierung einer Auswahl/Menü-Taste, eine Aktivierung einer Kindersicherung (7), eine Aktivierung eines Wischschutzes (7) und/oder eine Aktivierung einer Kochstelle (3a-d) durch Betätigen eines Hauptschalters (4).

15. Verfahren zum Betreiben eines Haushaltsgeräts (1, G) nach einem der vorhergehenden Ansprüche, **dadurch gekennzeichnet, dass** zumindest eine aufgrund einer mindestens eine vorbestimmte Zeitdauer dauernden Dauerbetätigung zuletzt durchgeführte Änderung eines Betriebsparameters mittels eines Bedieners durch Betätigen eines Rücksetz-Bedienelements (13) erst dann zurückgesetzt wird, wenn keine Fehlbetätigung mehr vorliegt.

## Claims

1. Household appliance (1, G) with at least one control element (4, 5a-d, 6a-d, 7-12) for modifying at least one operating parameter of the household appliance (1, G) and a control facility, which household appliance (1, G) additionally has a reset control element (13), which is provided for resetting at least one modification most recently made by means of the at least one other control element (4, 5a-d, 6a-d, 7-12), **characterised in that** the resetting by the reset control element (13) can only then be triggered by the control facility if no faulty actuation of the at least one other control element (4, 5a-d, 6a-d, 7-12) exists in the form of a permanent actuation, which is then assumed if at least one predetermined period of time has been reached or exceeded.

2. Household appliance (1, G) according to claim 1, **characterised in that** the reset control element (13) is configured for resetting a number of modifications most recently made.

3. Household appliance (1, G) according to one of the preceding claims, **characterised in that** the at least one operating parameter is modified as a result of precisely one actuation of an associated control element (5d).

4. Household appliance (1, G) according to one of the preceding claims, **characterised in that**
- at least one operating parameter is modified as a result of a number of actuations of at least one control element (5d) carried out consecutively, wherein actuations carried out consecutively do not go beyond a first predetermined period of time and
- this modification is reset by means of a single actuation of the reset control element (13).

5. Household appliance (1, G) according to claim 4, **characterised in that** the predetermined first period of time amounts to at least three seconds.

6. Household appliance (1, G) according to one of the preceding claims, **characterised in that** a modification is able to be reset up to a second predetermined period of time, especially approximately five minutes.

7. Household appliance (1, G) according to claim 6, **characterised in that** a modification is able to be reset after the household appliance (1, G) has been switched off, up to a third predetermined period of time, which is shorter than the second predetermined period of time.

8. Household appliance (1, G) according to one of the preceding claims, **characterised in that** specific modifications are able to be reset and other modifications are not able to be reset.

9. Household appliance (1, G) according to one of the preceding claims, **characterised in that** the reset control element (13) is coupled to a memory facility, wherein the memory facility is configured to store the at least one modification most recently made and to restore the at least one modification with a respective actuation of the reset control element (13).

10. Household appliance (1, G) according to one of the preceding claims, **characterised in that** at least one operating parameter, especially at least one current period of time, is stored with each modification which it undergoes.

11. Household appliance (1, G) according to one of the preceding claims, **characterised in that** the storage of a modification is able to be erased automatically if the associated at least one operating parameter has not been changed by the modification especially without taking account of a least one current period of time.

12. Household appliance (1, G) according to one of the preceding claims, **characterised in that** the household appliance is a cooking device (G) with a cooktop (1).

13. Household appliance (1, G) according to claim 12 in conjunction with claim 8, **characterized in that** the following modifications are able to be reset: an adjustment of a heat setting, an adjustment of a zone addition, an adjustment of a heat boost and/or an adjustment of a timer time.

14. Household appliance (1, G) according to one of claims 12 or 13 in conjunction with claim 8, **characterised in that** the following modifications are not able to be reset: an activation of a timer (9), an activation of a roasting sensor system, an activation of an automatic program system, an activation of a selection/menu button, an activation of a child lock (7), an activation of a wipe protection (7) and/or an activation of a hotplate (3a-d) by actuating a main switch (4).

15. Method for operating a household appliance (1, G) according to one of the preceding claims, **characterised in that** at least one modification of an operating parameter most recently made on account of a permanent actuation lasting at least one predetermined period of time is only then reset by means of an operator by actuating a reset control element (13) if there is no longer any faulty actuation.

## Revendications

1. Appareil ménager (1, G) avec au moins un élément de commande (4, 5a-d, 6a-d, 7-12) pour la modification d'au moins un paramètre de fonctionnement de l'appareil ménager (1, G) et un dispositif de commande, lequel appareil ménager (1, G) présente en outre un élément de commande de réinitialisation (13), prévu afin de réinitialiser au moins une modification effectuée en dernier lieu au moyen de l'au moins un autre élément de commande (4, 5a-d, 6a-d, 7-12), **caractérisé en ce que** la réinitialisation via l'élément de commande de réinitialisation (13) peut uniquement être déclenchée par le dispositif de commande en l'absence d'un actionnement erroné de l'au moins un autre élément de commande (4, 5a-d, 6a-d, 7-12) sous la forme d'un actionnement en continu, supposé à l'atteinte ou au dépassement d'au moins une durée prédéterminée.

2. Appareil ménager (1, G) selon la revendication 1, **caractérisé en ce que** l'élément de commande de réinitialisation (13) est aménagé pour la réinitialisation de plusieurs modifications effectuées en dernier lieu.

3. Appareil ménager (1, G) selon l'une des revendications précédentes, **caractérisé en ce qu'**une modification de l'au moins un paramètre de fonctionnement s'effectue en raison de précisément un actionnement d'un élément de commande correspondant (5d).

4. Appareil ménager (1, G) selon l'une des revendications précédentes, **caractérisé en ce que**
- une modification de l'au moins un paramètre de fonctionnement s'effectue en raison de plusieurs actionnements consécutifs d'au moins un élément de commande (5d), dans lequel les actionnements consécutifs n'excèdent pas une première durée prédéterminée et
- cette modification se réinitialise au moyen d'un seul actionnement de l'élément de commande de réinitialisation (13).

5. Appareil ménager (1, G) selon la revendication 4, **caractérisé en ce que** la première durée prédéterminée comporte au moins trois secondes.

6. Appareil ménager (1, G) selon l'une des revendications précédentes, **caractérisé en ce qu'**une modification est réinitialisable jusqu'à une deuxième durée prédéterminée, en particulier environ cinq minutes.

7. Appareil ménager (1, G) selon la revendication 6, **caractérisé en ce qu'**une modification est réinitialisable jusqu'à une troisième durée prédéterminée inférieure à la deuxième durée prédéterminée après une extinction de l'appareil ménager (1, G).

8. Appareil ménager (1, G) selon l'une des revendications précédentes, **caractérisé en ce que** des modifications déterminées sont réinitialisables et d'autres modifications ne sont pas réinitialisables.

9. Appareil ménager (1, G) selon l'une des revendications précédentes, **caractérisé en ce que** l'élément de commande de réinitialisation (13) est couplé à un dispositif d'enregistrement, dans lequel le dispositif d'enregistrement est configuré afin d'enregistrer au moins une modification effectuée en dernier lieu et de restaurer l'au moins une modification avec un actionnement respectif de l'élément de commande de réinitialisation (13).

10. Appareil ménager (1, G) selon l'une des revendications précédentes, **caractérisé en ce qu'**au moins un paramètre de fonctionnement, en particulier au moins une durée en cours, est enregistré avec chacune de ses modifications.

11. Appareil ménager (1, G) selon l'une des revendications précédentes, **caractérisé en ce qu'**un enregistrement d'une modification est automatiquement effaçable dans le cas où l'au moins un paramètre de fonctionnement correspondant, en particulier sans prise en compte d'au moins une durée en cours, n'a pas été modifié par la modification.

12. Appareil ménager (1, G) selon l'une des revendications précédentes, **caractérisé en ce que** l'appareil ménager est un appareil de cuisson (G) avec un champ de cuisson (1).

13. Appareil ménager (1, G) selon la revendication 12 en lien avec la revendication 8, **caractérisé en ce que** les modifications suivantes sont réinitialisables : un réglage d'un niveau de cuisson, un réglage d'une activation de zones, un réglage d'un début de cuisson et/ou un réglage d'une durée de minuterie.

14. Appareil ménager (1, G) selon l'une des revendications 12 ou 13 en lien avec la revendication 8, **caractérisé en ce que** les modifications suivantes ne sont pas réinitialisables : une activation d'une minuterie (9), une activation d'une technologie de capteurs concernant la cuisson, une activation d'un programme automatique, une activation d'une touche sélection/menu, une activation d'une sécurité enfants (7), une activation d'une protection de nettoyage (7) et/ou une activation d'un foyer de cuisson (3a-d) en actionnant un interrupteur principal (4).

15. Procédé d'exploitation d'un appareil ménager (1, G) selon l'une des revendications précédentes, **caractérisé en ce qu'**un utilisateur réinitialise au moins une modification d'un paramètre de fonctionnement effectuée en dernier lieu en raison d'un actionnement en continu durant au moins une durée prédéterminée en actionnant un élément de commande de réinitialisation (13) uniquement lorsque plus aucun actionnement erroné n'existe.
